# EUROPÄISCHE PATENTSCHRIFT

(11) **EP 1 328 899 B1**
(45) Veröffentlichungstag und Bekanntmachung des Hinweises auf die Patenterteilung: **18.01.2006**
(21) Anmeldenummer: 01982363.2
(22) Anmeldetag: 26.09.2001
(51) Int. Cl.: G06K 19/077

(54) **VERFAHREN ZUR HERSTELLUNG EINER TRANSPONDERSPULE**
METHOD FOR PRODUCING A TRANSPONDER COIL
PROCEDE DE FABRICATION D'UNE BOBINE DE TRANSPONDEUR

(30) Priorität: 27.09.2000 DE 10047972
(43) Veröffentlichungstag der Anmeldung: 23.07.2003
(73) Patentinhaber: Giesecke & Devrient GmbH, 81677 München (DE)
(72) Erfinder: HOPPE, Joachim, 81377 München (DE); HOHMANN, Arno, 81369 München (DE)
(74) Vertreter: Klunker . Schmitt-Nilson . Hirsch
(86) Internationale Anmeldenummer: PCT/EP2001/011145
(87) Internationale Veröffentlichungsnummer: WO 2002/027651

(56) Entgegenhaltungen:
- EP-A- 1 100 296
- DE-A- 4 410 732
- DE-A- 4 421 607
- US-A- 3 130 257

## Beschreibung

Die vorliegende Erfindung betrifft ein Verfahren zur Herstellung einer Transponderspule für einen Datenträger gemäß dem Oberbegriff des Anspruchs 1. Darüber hinaus betrifft die Erfindung einen Datenträger gemäß dem Oberbegriff des Anspruchs 9.

Transponderspulen dienen als Antennen für die Übertragung von Energie und/ oder Daten zwischen dem Datenträger und einem Terminal. Unter dem Begriff Terminal ist hierbei jedes Gerät mit einer Sende- oder Empfangseinrichtung zur Kommunikation bzw. Energieübertragung zwischen dem Gerät und dem Datenträger zu verstehen. Insbesondere werden solche Transponderspulen in kontaktlosen Chipkarten eingesetzt. Weitere Einsatzmöglichkeiten sind beispielsweise Datenträger in Form von Implantaten zur Kennzeichnung von Tieren oder als medizinische Kleinstgeräte sowie die Verwendung zur Diebstahlsicherung beispielsweise von Waren in Kaufhäusern.

Zur Herstellung einer Transponderspule für eine Chipkarte wird in der DE 44 21607 A1 ein Verfahren beschrieben, bei dem zunächst mit Hilfe eines Spulenwickelapparates aus einem elektrisch leitfähigen Draht eine Spule gewickelt wird, deren Windungen sich alle in einer Ebene befinden. Diese Spule wird auf eine Folie aufgelegt und beispielsweise durch Aufdrücken eines beheizten Stempels mit der Folie verbunden. Als Alternative wird vorgeschlagen, die Drahtspule auf die Folie aufzulegen und mittels eines Fixierfadens aus Kunststoff auf der Folie festzunähen. Auf der Folie befindet sich außerdem ein elektronisches Modul, das mit der Spule verbunden wird. Die vollständig bestückte Folie wird dann als eine Schicht in eine Chipkarte eingebaut, so daß sich das elektronische Modul einschließlich Spule im Inneren der Chipkarte befinden.

Dokument DE 44 21 607 A1 zeigt ein Verfahren zur Herstellung einer zumindest einen Chip und eine Spule aufweisenden Transpondereinheit, bei dem der Chip und die Spule auf einem gemeinsamen Substrat angeordnet werden. Die Ausbildung der Spule erfolgt durch Verlegen eines Spulendrahts auf dem gemeinsamen Substrat. Der Spulendraht wird unter Druck- und Temperatureinwirkung in das Substrat eingeschmolzen, um eine mechanische Verbindung zwischen Spule und Substrat zu erzielen.

Es ist Aufgabe der vorliegenden Erfindung, eine Alternative zu diesem bekannten Stand der Technik zu schaffen, welche eine wirtschaftlichere Herstellung von Transponderspulen und von Datenträgern mit Transponderspulen ermöglicht.

Diese Aufgabe wird durch ein Verfahren gemäß Patentanspruch 1 bzw. durch einen Datenträger gemäß Anspruch 9 gelöst. In den davon abhängigen Ansprüchen sind vorteilhafte Weiterbildungen und Ausgestaltungen der Erfindung angegeben.

Bei einer ersten Ausführungsform wird die Transponderspule selbst als Nähfaden zum Festnähen der Transponderspule auf dem Datenträger oder der Trägerschicht des Datenträgers verwendet. Das heißt, der die Transponderspule bildende elektrisch leitfähige Draht bzw. Faden wird hierbei nähtechnisch als aktiver Faden eingesetzt und ist selbst an der Nähstichbildung beteiligt. Auf die Verwendung eines zusätzlichen Fixierfadens zum Festnähen der Transponderspule kann dann vollständig verzichtet werden. Anstelle der gemäß dem eingangs genannten Stand der Technik benötigten drei Verfahrensschritte - Wicklung einer Spule, Auflegen der Spule und anschließendes Fixieren mittels eines Fixierfadens - wird hier die vollständige Transponderspule in einem Arbeitsgang durch direktes Aufnähen des elektrisch leitfähigen Fadens selbst erzeugt.

Dabei besteht zusätzlich die vorteilhafte Möglichkeit, eine Kontaktierung zu anderen auf der Trägerschicht bzw. im Datenträger vorhandenen Bauteilen automatisch mittels nähtechnischer Verfahren in einem Arbeitsgang herzustellen. Dabei wird das Faden- bzw. Drahtende mit dem gewünschten elektronischen Bauteil kontaktiert, indem der Faden direkt mit dem elektrischen Kontakt des Bauteils, beispielsweise einem Kontakt-Pad auf der Trägerschicht, vernäht wird.

Da bei dieser Technik der Faden, der die Transponderspule bildet, ständig durch den Datenträger bzw. die Trägerschicht des Datenträgers geführt wird und sich mal auf der einen und mal auf der anderen Seite des Datenträgers bzw. der Trägerschicht befindet, sind durch geeignete Anordnung der Nähstiche Überkreuzungen mit anderen Drähten bzw. Fäden oder Leiterbahnen ohne weiteres realisierbar.

Bei einer alternativen zweiten Ausführungsform wird ein erster elektrisch leitfähiger Faden, welcher die Transponderspule bildet, mittels eines zweiten elektrisch leitfähigen Fadens, welcher als Nähfaden auf den Datenträger oder auf die Trägerschicht des Datenträgers genäht wird, auf dem Datenträger oder der Trägerschicht des Datenträgers fixiert. Diese Ausführungsform kann so realisiert werden, daß der die Transponderspule bildende Faden selbst nicht an der Nähstichbildung beteiligt ist, sondern nur auf einer Seite des Datenträgers bzw. der Trägerschicht des Datenträgers aufliegt und von dem zweiten elektrisch leitfähigen Faden gehalten wird.

Bei einer speziellen Variante hierzu werden jedoch der erste elektrisch leitfähige Faden, welcher die Transponderspule bildet, und der zweite elektrisch leitfähige Faden nach Art eines Unter- und Oberfadens auf dem Datenträger oder der Trägerschicht des Datenträgers vernäht. Hierbei sind beide Fäden an der Nähstichbildung beteiligt, wobei einer der beiden Fäden durch das Nähstichloch hindurchgeführt wird und den jeweils anderen Faden umschlingt und in das Nähstichloch hineinzieht. Wie weit der aufgelegte Faden in das Nähstichloch hineingezogen wird, wird durch die Spannung der Fäden beim Nähen bestimmt.

Bei der zweiten Ausführungsform mit dem zusätzlichen elektrisch leitfähigen Faden zur Fixierung der Transponderspule auf dem Datenträger bzw. der Trägerschicht des Datenträgers wird vorzugsweise der zweite elektrisch leitfähige Faden derart ausgebildet, daß er eine Sekundärtransponderspule bildet. Diese Sekundärtransponderspule kann unabhängig neben der von dem ersten Faden gebildeten Transponderspule betrieben werden. Der zur Fixierung verwendete zweite elektrisch leitfähige Faden hat dann auch nach der Herstellung noch einen Nutzen innerhalb des Datenträgers. Über die Sekundärtransponderspule können beispielsweise zusätzliche Informationen zwischen der Karte und dem Terminal ausgetauscht werden. Vorzugsweise handelt es sich bei diesen zusätzlichen Informationen um Sicherheitsdaten.

Da beispielsweise bei einer kontaktlosen Chipkarte die notwendige Energieversorgung über die eigentliche Transponderspule erfolgt, kann für die Sekundärtransponderspule, d.h. als zweiter elektrisch leitfähiger Faden, ein Faden mit einer geringeren Leitfähigkeit eingesetzt werden.

Selbstverständlich können auch bei diesen weiteren genannten Verfahren die Enden der Fäden jeweils direkt mit einem elektrischen Kontakt eines Bauteils vernäht werden.

Da sich die beiden elektrisch leitfähigen Fäden aufgrund der Vernähung berühren, sollte zumindest einer der beiden Fäden mit einer Isolierschicht versehen sein, so daß zwischen den beiden Spulen kein elektrischer Kontakt besteht. Die Transponderspule bzw. ggf. die Sekundärtransponderspule werden vorzugsweise auf einer Inlett-Folie als Trägerschicht erzeugt. Diese Inlett-Folie wird dann auf die übliche Weise bei der Herstellung der Chipkarte in die Chipkarte eingebracht. Hierbei kommen beispielsweise die allgemein bekannten Laminier- und Klebeverfahren in Frage.

Vorzugsweise befindet sich auf der Inlett-Folie, welche die Transponderspule und ggf. die Sekundärtransponderspule trägt, auch der Chip der Chipkarte so daß bei der Erzeugung der Transponderspule bzw. der Sekundärtransponderspule, beispielsweise durch die genannte Vernähung, eine einfache Kontaktierung mit dein Chip möglich ist.

Der fertige Datenträger weist somit eine aufgenähte Transponderspule auf, wobei der Nähfaden ein elektrisch leitfähiger Faden ist. Der Nähfaden kann hierbei selbst durch die Transponderspule gebildet werden. Die Transponderspule kann aber auch durch einen zweiten elektrisch leitfähigen Faden fixiert sein.

Mit dem erfindungsgemäßen Verfahren lassen sich beliebige Geometrien von Spulen erzeugen. Insbesondere können auch Strukturen erzeugt werden, bei denen überkreuzte Fäden auf einfache Weise realisiert werden.

Als Materialien für die Transponderspule können dabei beliebige Materialien mit optimalen elektrischen Eigenschaften ausgesucht werden. Insbesondere können als Fäden entsprechend geeignete Drähte aus Kupfer, aus Aluminium oder aus einer anderen günstigen metallischen Legierung gewählt werden. Selbstverständlich ist es auch möglich, Fäden aus leitfähigen Polymeren zu wählen. Außerdem können die Fäden beispielsweise auch mit fluoreszierenden Merkmalsstoffen getränkt sein oder andere nachweisbare physikalische Merkmale aufweisen, wie z.B. magnetische Stoffe. Dies bietet sich insbesondere bei dem zur Fixierung dienenden, zweiten Faden an, welcher keine höhere Leitfähigkeit aufweisen muß, und der auf diese Weise gleichzeitig als "Sicherheitsfaden" dient.

Es versteht sich von selbst, daß bei der Verwendung von mehreren leitfähigen Fäden die Fäden auch aus unterschiedlichen Materialien bestehen können.

Die Erfindung wird im Folgenden unter Hinweis auf die beigefügten Zeichnungen anhand von verschiedenen Ausführungsbeispielen näher erläutert. Die dort dargestellten Merkmale und auch die bereits oben beschriebenen Merkmale können nicht nur in den genannten Kombinationen, sondern auch einzeln oder in anderen Kombinationen erfindungswesentlich sein. Es zeigen:
- Fig. 1: eine schematische Darstellung einer Inlett-Folie für eine Chipkarte mit einer erfindungsgemäß aufgebrachten Transponderspule, wobei der die Transponderspule bildende Faden als Nähfaden dient;
- Fig. 2: eine schematische Darstellung einer Inlett-Folie für eine Chipkarte mit einer erfindungsgemäß aufgebrachten Transponderspule, wobei der die Transponderspule bildende Faden durch einen zweiten elektrisch leitfähigen Faden fixiert wird;
- Fig. 3: ein Ausschnitt einer vergrößerten Schnittdarstellung eines eine Transponderspule bildenden, auf eine Inlett-Folie genähten Fadens;
- Fig. 4: eine Ausschnitt einer vergrößerten Schnittdarstellung eines eine Transponderspule bildenden Fadens, der unter Verwendung eines zweiten elektrisch leitfähigen Fadens auf eine Inlett-Folie aufgenäht ist;
- Fig. 5 a: eine schematische Darstellung der räumlichen Anordnung der Nähstiche und eines die Transponderspule bildenden Fadens gemäß einem ersten Ausführungsbeispiel;

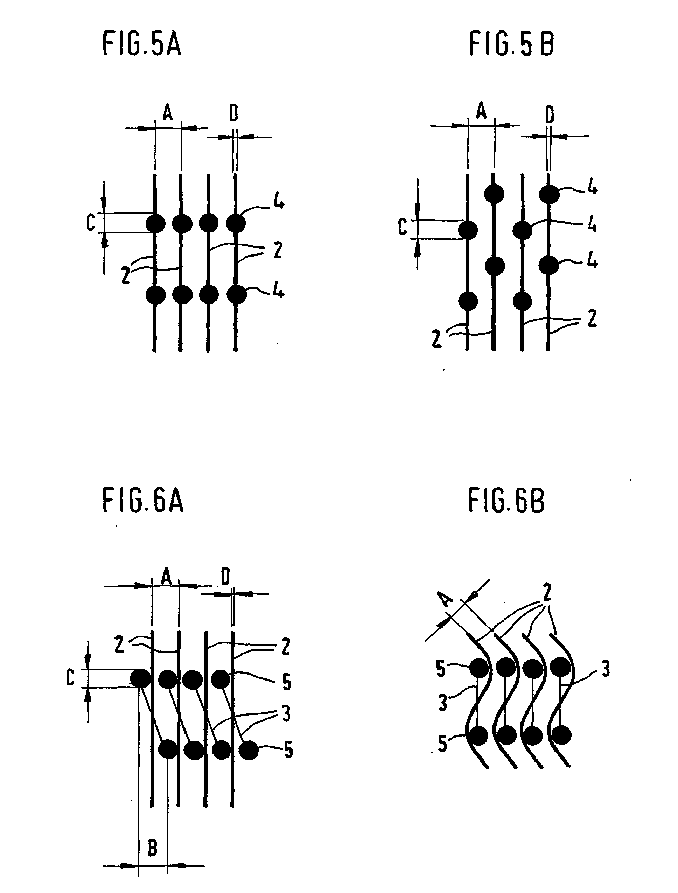

- Fig. 5 b: eine schematische Darstellung der räumlichen Anordnung der Nähstiche und eines die Transponderspule bildenden Fadens gemäß einem zweiten Ausführungsbeispiel;
- Fig. 6 a: eine schematische Darstellung der räumlichen Anordnung der Nähstiche, eines die Transponderspule bildenden ersten Fadens und eines eine Sekundärtransponderspule bildenden zweiten Fadens gemäß einem ersten Ausführungsbeispiel;
- Fig. 6 b: eine schematische Darstellung der räumlichen Anordnung der Nähstiche, eines die Transponderspule bildenden ersten Fadens und eines eine Sekundärtransponderspule bildenden zweiten Fadens gemäß einem zweiten Ausführungsbeispiel.

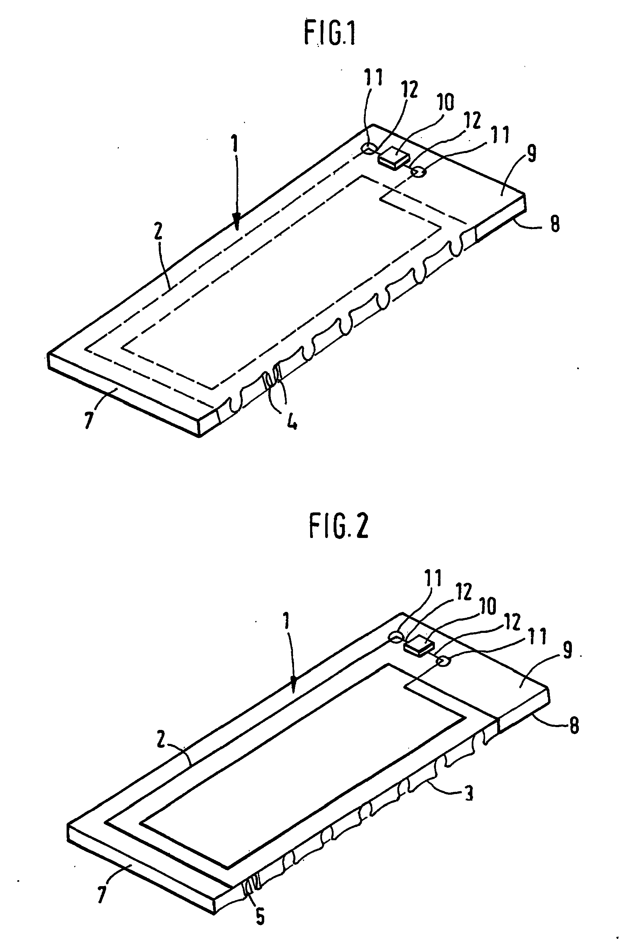

In dem Ausführungsbeispiel gemäß Figur 1 besteht die Transponderspule 1 aus einem leitfähigen Draht 2, welcher direkt auf ein Substrat, hier eine Inlett-Folie 7 für eine Chipkarte, aufgenäht ist. Bei dem Faden 2 handelt es sich in dem gezeigten Ausführungsbeispiel um einen dünnen Kupferdraht. Dieser die Transponderspule 1 bildende Kupferdraht 2 wird dabei selbst als Nähfaden verwendet. D.h. er wird wechselseitig durch die Inlett-Folie 7 an Nähstichlöchern 4, wie an der vorderen Schnittkante der Figur 1 dargestellt, hindurchgeführt.

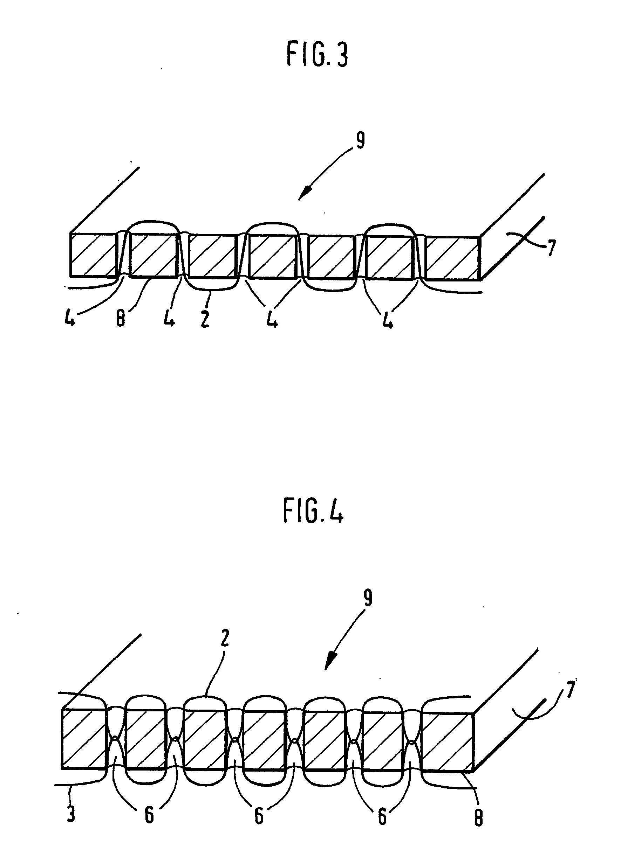

Figur 3 zeigt das Vernähen des elektrisch leitfähigen Fadens 2 mit der Inlett-Folie 7 in vergrößerter Darstellung. Es handelt sich hierbei um einen "Einfachsteppstich", der in der Textiltechnik auch als Vor- oder Heftstich bezeichnet wird und der dort üblicherweise dazu dient, mehrere Stoffteile zusammenzuheften. Hierbei wird der Faden 2 wechselweise von unten nach oben und von oben nach unten durch die Inlett-Folie 7 gestochen, d.h. er verläuft in einer geraden Vorwärtsrichtung abschnittsweise mal auf der Oberseite 9 und mal auf der Unterseite 8 der Inlett-Folie 7. Der Faden 2 ist dabei allen Wirkmechanismen bei der Nähstichbildung ausgesetzt.

In den Figuren 5 a und 5 b sind schematisch zwei verschiedene mögliche Anordnungen der Nähstiche und der Fadenläufe zueinander dargestellt. Wie diese Figuren zeigen, ist der Abstand A zweier nebeneinander verlaufender Fäden 2, d.h. zweier benachbarter Spulenwindungen, auf der Inlett-Folie 7 bei geradliniger Anordnung der Nähstiche 4 im wesentlichen von der Dicke D des verwendeten Fadens 2, dem Durchmesser C der verwendeten Nähmaschinennadel sowie der Lage der Nähstiche 4 auf der Nahtlinie abhängig. Bei einer versetzten Anordnung der Nähstiche 4 gemäß Figur 5 b ist ein engerer Windungsabstand A möglich als bei einer parallel nebeneinander liegenden Anordnung der Nähstiche 4 wie in Figur 5 a. Ein Windungsabstand A von ca. 1 mm ist hierdurch realisierbar.

An den Enden der Transponderspule 1 (Fig.1) ist der Faden 2 jeweils mit einem Kontakt-Pad 11 auf der Inlett-Folie 7 vernäht. Diese Kontakt-Pads 11 sind mit einem auf der Inlett-Folie 7 angeordneten Chip 10 über Drahtbrükken 12 (z.B. übliche Bonding-Drähte) verbunden, so daß ein entsprechender Kontakt zwischen der Transponderspule 1 und dem Chip 10 besteht.

Figur 2 zeigt in ähnlicher Darstellung wie Figur 1 ein zweites Ausführungsbeispiel, bei dem der die Transponderspule 1 bildende Draht oder elektrisch leitfähige Faden 2 nur auf der Oberseite 9 der Inlett-Folie 7 aufgelegt ist. Die Fixierung erfolgt mit einem zweiten elektrisch leitfähigen Faden 3, welcher nun wechselseitig von oben und von unten durch die Inlett-Folie 7 gestochen wird und so unter Fixierung des ersten, die Transponderspule 1 bildenden Fadens 2 mit der Inlett-Folie 7 vernäht wird. In Figur 2 ist die Vernähung des zur Fixierung dienenden zweiten Fadens 3 nur an der vorderen Schnittkante dargestellt. Selbstverständlich erfolgt eine entsprechende Fixierung vorzugsweise über die gesamte Länge des die Transponderspule 1 bildenden Fadens 2.

Auch bei diesem Ausführungsbeispiel wird als Faden 2 zur Bildung der Transponderspule 1 ein Kupferdraht verwendet. Dieser Kupferdraht wird als passives Fadensystem (vorgelegter Faden) mittels der im Nähprozeß erzeugten Schlingen oder Schlaufen des zur Fixierung eingesetzten leitfähigen Fadens 3 auf der Inlett-Folie 7 befestigt, so daß der Kupferdraht selbst den Wirkmechanismen bei der Nähstichbildung im wesentlichen nicht ausgesetzt wird. Das Zuführen des Kupferdrahtes kann mittels geeigneter Vorrichtungen auf der Oberseite 9 der Inlett-Folie 7, d.h. nadelseitig, erfolgen. Die Spulenwindungen liegen dabei vollständig auf einer Seite, hier der Oberseite 9, der Inlett-Folie 7.

In den Figuren 6 a und 6 b sind verschiedene Möglichkeiten der räumlichen Anordnung der Nähstiche 5 und des räumlichen Verlaufs der Fäden 2, 3 dargestellt. Wie die beiden Figuren zeigen, kann der die Transponderspule bildende Faden 2 in Abhängigkeit vom gewählten Nähstichtyp und vom eingesetzten Zuführverfahren entweder gestreckt, wie in Figur 6 a, oder gewunden, wie in Figur 6 b, auf der Inlett-Folie 7 fixiert werden. Der Abstand A der Spulenwindungen ist zum einen von der Anordnung bzw. dem Abstand B der Nähstiche 5, dem Durchmesser C der Nähmaschinennadel sowie dem Durchmesser D des die Transponderspule 1 bildenden Fadens 2 abhängig. Auch bei diesem Verfahren ist ein Windungsabstand A von 1 mm realisierbar.

Figur 4 zeigt in vergrößerter Darstellung eine weitere Variante, bei welcher der die Transponderspule 1 bildende Faden 2 mittels eines zweiten elektrisch leitfähigen Fadens 3 auf der Inlett-Folie 7 fixiert wird. Hierbei handelt es sich um einen "Doppelsteppstich" mit zwei aktiven Fadensystemen. Das heißt, es sind sowohl der die Transponderspule 1 bildende Faden 2 als auch der zur Fixierung dienende Faden 3 an der Nähstichbildung beteiligt. Die Vernähung erfolgt nach Art eines Unter- und Oberfadens wie bei dem in der Textiltechnik unter den Begriffen "Geradstich" oder "Steppstich" allgemein bekannten maschinellen Verfahren.

Der zweite elektrisch leitfähige Faden 3 wird hierbei mittels der Nähmaschinennadel von unten durch das Nähstichloch 6 nach oben geführt und als Schlaufe über den von oben zugeführten, die Transponderspule 1 bildenden Faden 2 gelegt. Anschließend wird der zur Fixierung dienende Faden 3 wieder durch das gleiche Nähstichloch 6 nach unten geführt und zieht dabei den die Transponderspule bildenden Faden 2 mit in das Nähstichloch 6 hinein. Selbstverständlich kann das Verfahren auch umgekehrt durchgeführt werden. Das heißt, es wird der die Transponderspule bildende Faden 2 durch das Nähstichloch 6 hin- und zurückgeführt und zieht den zur Fixierung dienenden Faden 3 in das Nähstichloch 6 hinein.

Bei den gezeigten Verfahren wird der erste Faden 2, welcher die Transponderspule 1 bildet, an den Enden der Transponderspule 1 mit einem auf der Inlett-Folie 7 angeordneten Chip 10 kontaktiert. Außerdem wird -sofern vorhanden - der zur Fixierung dienende zweite elektrisch leitfähige Faden 3 als zweite Sekundärtransponderspule genutzt. Das heißt, auch die Enden dieses zweiten Fadens 3 werden mit entsprechenden Eingängen des Chips 10 oder mit einem separaten zweiten Chip kontaktiert.

Entweder der die Transponderspule bildende Faden 2 oder der zur Fixierung dienende, die Sekundärtransponderspule bildende Faden 3 weist eine Isolierschicht auf, so daß zwischen den beiden Transponderspulen keinerlei elektrischer Kontakt auftritt. Die beiden Transponderspulen sind daher unabhängig voneinander funktionsfähig.

Die Sekundärtransponderspule kann dazu genutzt werden, unabhängig von der Transponderspule 1 zusätzliche Daten zu einem Terminal zu übermitteln bzw. von einem Terminal zu empfangen, wobei es sich bei diesen zusätzlichen Daten vorzugsweise um Sicherheitsdaten handelt. Unter dem Begriff Sicherheitsdaten sind hierbei Daten zu verstehen, die zur Absicherung der Karte gegen Mißbrauch, unbefugte Benutzung oder unbefugtes Ausspionieren der auf der Karte gespeicherten Daten dienen können. Hierbei kann es sich beispielsweise um Codes zur Authentisierung oder zur Codierung der übertragenen Daten handeln.

Die so erzeugte Inlett-Folie 7 mit dem Chip 10 und der Transponderspule 1 sowie gegebenenfalls der Sekundärtransponderspule kann mit den herkömmlichen Klebe- und Lamirdertechniken als innere Schicht in eine Chipkarte implementiert werden. Es sind keine speziellen Fertigungsmethoden zum Einbau der Inlett-Folie in eine Chipkarte notwendig. Das erfindungsgemäße Verfahren kann auch problemlos in solchen Chipkartenherstellungsverfahren angewendet werden, bei denen größere Folienbögen mit mehreren Nutzen verarbeitet werden.

## Patentansprüche

1. Verfahren zur Herstellung einer Transponderspule (1) für einen Datenträger, wobei die Transponderspule (1) auf den Datenträger oder auf eine Trägerschicht (7) des Datenträgers aufgenäht wird und zum Aufnähen mindestens ein Nähfaden verwendet wird, **dadurch gekennzeichnet, daß** als Nähfaden ein elektrisch leitfähiger Faden (2, 3), nämlich die Transponderspule (1) selbst verwendet wird.

2. Verfahren nach Anspruch 1, **dadurch gekennzeichnet, daß** ein die Transponderspule (1) bildender erster elektrisch leitfähiger Faden (2) mittels eines zweiten elektrisch leitfähigen Fadens (3) auf dem Datenträger oder der Trägerschicht (7) des Datenträgers fixiert wird, wobei der zweite elektrisch leitfähige Faden (3) als Nähfaden auf den Datenträger oder die Trägerschicht (7) des Datenträgers genäht wird.

3. Verfahren nach Anspruch 2, **dadurch gekennzeichnet, daß** der die Transponderspule (1) bildende erste elektrisch leitfähige Faden (2) mit dem zweiten elektrisch leitfähigen Faden (3) nach Art eines Unter- und Oberfadens auf dem Datenträger oder der Trägerschicht (7) des Datenträgers vernäht wird.

4. Verfahren nach einem der Ansprüche 2 oder 3, **dadurch gekennzeichnet, daß** der zweite elektrisch leitfähige Faden (3) derart ausgebildet wird, daß er eine Sekundärtransponderspule bildet, welche zusätzlich zu der von dem ersten Faden (2) gebildeten Transponderspule (1) betrieben werden kann.

5. Verfahren nach einem der Ansprüche 1 bis 4, **dadurch gekennzeichnet, daß** als elektrisch leitfähiger Faden (2, 3) ein Draht aus Kupfer oder aus Aluminium oder aus einer metallischen Legierung oder aus leitfähigen Polymeren verwendet wird.

6. Verfahren nach einem der Ansprüche 1 bis 5, **dadurch gekennzeichnet, daß** der Datenträger eine Chipkarte ist.

7. Verfahren nach Anspruch 6, **dadurch gekennzeichnet, daß** die Transponderspule (1) auf einer Trägerschicht (7) erzeugt wird, die als Inlett-Folie bei der Herstellung der Chipkarte in die Chipkarte eingebracht wird.

8. Verfahren nach Anspruch 7, **dadurch gekennzeichnet, daß** auf die Inlett-Folie ein Chip (10) aufgebracht wird.

9. Datenträger mit einer auf dem Datenträger oder auf einer Trägerschicht (7) des Datenträgers mittels mindestens eines Nähfadens aufgenähten Transponderspule (1), **dadurch gekennzeichnet, daß** der Nähfaden ein elektrisch leitfähiger Faden (2, 3) ist, der durch die Transponderspule (1) selbst gebildet wird.

10. Datenträger nach Anspruch 9, **gekennzeichnet durch** einen die Transponderspule (1) bildenden ersten elektrisch leitfähigen Faden (2) und **durch** einen zweiten elektrisch leitfähigen Faden (3), welcher als Nähfaden auf den Datenträger oder die Trägerschicht (7) des Datenträgers genäht ist und den ersten Faden (2) auf dem Datenträger oder der Trägerschicht (7) des Datenträgers fixiert.

11. Datenträger nach Anspruch 10, **dadurch gekennzeichnet, daß** der die Transponderspule (1) bildende erste elektrisch leitfähige Faden (2) und der zweite elektrisch leitfähige Faden (3) nach Art eines Unter- und Oberfadens auf dem Datenträger oder der Trägerschicht (7) des Datenträgers vernäht sind.

12. Datenträger nach Anspruch 10 oder 11, **dadurch gekennzeichnet, daß** der zweite elektrisch leitfähige Faden (3) eine Sekundärtransponderspule bildet.

13. Datenträger nach einem der Ansprüche 9 bis 12, **dadurch gekennzeichnet, daß** der elektrisch leitfähige Faden (2, 3) ein Draht aus Kupfer oder aus Aluminium oder aus einer metallischen Legierung oder aus leitfähigen Polymeren ist.

14. Datenträger nach einem der Ansprüche 9 bis 13, **dadurch gekennzeichnet, daß** der Datenträger eine Chipkarte ist.

15. Datenträger nach Anspruch 14, **dadurch gekennzeichnet, daß** die Trägerschicht (7) mit der Transponderspule (1) innerhalb der Chipkarte als Inlett-Folie (7) angeordnet ist.

16. Datenträger nach Anspruch 15, **dadurch gekennzeichnet, daß** die Inlett-Folie einen Chip (10) trägt.

17. Verwendung eines Datenträgers gemäß einem der Ansprüche 12 bis 16 **dadurch gekennzeichnet, daß** der Datenträger über die Sekundärtransponderspule unabhängig von der Transponderspule (1) zusätzliche Daten zu einem Terminal übermittelt und/oder von dem Terminal empfängt.

18. Verwendung eines Datenträgers nach Anspruch 17, **dadurch gekennzeichnet, daß** die zusätzlichen Daten Sicherheitsdaten sind.

## Claims

1. A method for producing a transponder coil (1) for a data carrier, wherein the transponder coil (1) is sewed onto the data carrier or onto a carrier layer (7) of the data carrier and for the sewing at least one sewing thread is used, **characterized in that** as a sewing thread an electrically conductive thread (2, 3), namely the transponder coil (1) itself is used.

2. The method according to claim 1, **characterized in that** a first electrically conductive thread (2) forming the transponder coil (1) by means of a second electrically conductive thread (3) is fixed onto the data carrier or the carrier layer (7) of the data carrier, the second electrically conductive thread (3) being sewed as a sewing thread onto the data carrier or the carrier layer (7) of the data carrier.

3. The method according to claim 2, **characterized in that** the first electrically conductive thread (2) forming the transponder coil (1) is sewed up with the second electrically conductive thread (3) in the manner of an under thread and upper thread onto the data carrier or the carrier layer (7) of the data carrier.

4. The method according to any of claims 2 or 3, **characterized in that** the second electrically conductive thread (3) is adapted to form a secondary transponder coil, which can be operated in addition to the transponder coil (1) formed by the first thread (2).

5. The method according to any of claims 1 to 4, **characterized in that** as an electrically conductive thread (2, 3) a wire made of copper or of aluminum or of a metallic alloy or of conductive polymers is used.

6. The method according to any of claims 1 to 5, **characterized in that** the data carrier is a chip card.

7. The method according to claim 6, **characterized in that** the transponder coil (1) is produced on a carrier layer (7), which is incorporated into the chip card as an inlay foil during the manufacturing of the chip card.

8. The method according to claim 7, **characterized in that** onto the inlay foil is applied a chip (10).

9. A data carrier with a transponder coil (1) sewed onto the data carrier or onto a carrier layer (7) of the data carrier by means of at least one sewing thread, **characterized in that** the sewing thread is an electrically conductive thread (2, 3), which is formed by the transponder coil (1) itself.

10. The data carrier according to claim 9, **characterized by** a first electrically conductive thread (2) forming the transponder coil (1) and by a second electrically conductive thread (3), which as a sewing thread is sewed onto the data carrier or the carrier layer (7) of the data carrier and fixes the first thread (2) onto the data carrier or the carrier layer (7) of the data carrier.

11. The data carrier according to claim 10, **characterized in that** the first electrically conductive thread (2) forming the transponder coil (1) and the second electrically conductive thread (3) are sewed up in the manner of an under thread and upper thread onto the data carrier or the carrier layer (7) of the data carrier.

12. The data carrier according to claim 10 or 11, **characterized in that** the second electrically conductive thread (3) forms a secondary transponder coil.

13. The data carrier according to any of claims 9 to 12, **characterized in that** the electrically conductive thread (2, 3) is a wire made of copper or of aluminum or of a metallic alloy or of conductive polymers.

14. The data carrier according to any of claims 9 to 13, **characterized in that** the data carrier is a chip card.

15. The data carrier according to claim 14, **characterized in that** the carrier layer (7) with the transponder coil (1) is disposed as an inlay foil (7) within the chip card.

16. The data carrier according to claim 15, **characterized in that** the inlay foil carries a chip (10).

17. A use of a data carrier according to any of claims 12 to 16, **characterized in that** the data carrier via the secondary transponder coil independently of the transponder coil (1) transmits additional data to a terminal and/or receives data from a terminal.

18. The use of a data carrier according to claim 17, **characterized in that** the additional data are security data.

## Revendications

1. Procédé de fabrication d'une bobine de transpondeur (1) pour un support de données, la bobine de transpondeur (1) étant montée par couture sur le support de données ou sur une couche support (7) du support de données et au moins un fil de couture étant utilisé pour l'opération de montage par couture, **caractérisé en ce qu'**on utilise comme fil de couture un fil (2,3) conducteur de l'électricité, précisément la bobine de transpondeur (1) elle-même.

2. Procédé selon la revendication 1, **caractérisé en ce qu'**un premier fil (2) conducteur de l'électricité, formant la bobine de transpondeur (1), est fixé, au moyen d'un deuxième fil (3) conducteur de l'électricité, sur le support de données ou sur la couche support (7) du support de données, le deuxième fil (3) conducteur de l'électricité, en tant que fil de couture, étant cousu sur le support de données ou la couche support (7) du support de données.

3. Procédé selon la revendication 2, **caractérisé en ce que** le premier fil (2) conducteur de l'électricité, formant la bobine de transpondeur (1), est cousu avec le deuxième fil (3) conducteur de l'électricité, à la façon d'un point noué sur le support de données ou sur la couche support (7) du support de données.

4. Procédé selon l'une des revendications 2 ou 3, **caractérisé en ce que** le deuxième fil (3) conducteur de l'électricité est réalisé de manière qu'il forme une bobine de transpondeur secondaire, pouvant être pilotée en plus de la bobine de transpondeur (1) formée par le premier fil (2).

5. Procédé selon l'une des revendications 1 à 4, **caractérisé en ce qu'**on utilise comme fil conducteur de l'électricité (2,3) un fil en cuivre, ou un fil en aluminium, ou en un alliage métallique, ou en un polymère conducteur.

6. Procédé selon l'une des revendications 1 à 5, **caractérisé en ce que** le support de données est une carte à puce électronique.

7. Procédé selon la revendication 6, **caractérisé en ce que** la bobine de transpondeur (1) est produite sur une couche support (7), introduite dans la carte à puce électronique, en tant que feuille d'insertion (Inlett), lors de la fabrication de la carte à puce électronique.

8. Procédé selon la revendication 7, **caractérisé en ce qu'**une puce électronique (10) est appliquée sur la feuille d'insertion (Inlett).

9. Support de données comprenant une bobine de transpondeur (1), cousue à l'aide d'au moins un fil sur le support de données ou sur une couche support (7) du support de données, **caractérisé en ce que** le fil de couture est un fil (2,3) conducteur de l'électricité, formé par la bobine de transpondeur (1) elle-même.

10. Support de données selon la revendication 9, **caractérisé par** un premier fil (2) conducteur de l'électricité, formant la bobine de transpondeur (1), et par un deuxième fil (3) conducteur de l'électricité, cousu en tant que fil de couture sur le support de données ou la couche support (7) du support de données et fixant le premier fil (2), sur le support de données ou sur la couche support (7) du support de données.

11. Support de données selon la revendication 10, **caractérisé en ce que** le premier fil (2) conducteur de l'électricité, formant la bobine de transpondeur (1), et le deuxième fil (3) conducteur de l'électricité sont cousus, à la façon d'un point noué, sur le support de données, ou sur la couche support (7) du support de données.

12. Support de données selon la revendication 10 ou 11, **caractérisé en ce que** le deuxième fil (3) conducteur de l'électricité forme une bobine de transpondeur secondaire.

13. Support de données selon l'une des revendications 9 à 12, **caractérisé en ce que** le fil (2,3) conducteur de l'électricité est un fil en cuivre, ou en aluminium, ou en un alliage métallique, ou en un polymère conducteur.

14. Support de données selon l'une des revendications 9 à 13, **caractérisé en ce que** le support de données est une carte à puce électronique.

15. Support de données selon la revendication 14, **caractérisé en ce que** la couche support (7) avec la bobine de transpondeur (1) est disposée à l'intérieur de la carte à puce électronique, en tant que feuille d'insertion (Inlett) (7).

16. Support de données selon la revendication 15, **caractérisé en ce que** la feuille d'insertion (Inlett) porte une puce électronique (10).

17. Utilisation d'un support de données selon les revendications 12 à 16, **caractérisé en ce que** le support de données transmet, par l'intermédiaire de la bobine de transpondeur secondaire, indépendamment de la bobine de transpondeur (1), des données supplémentaires, à un terminal et/ou reçoit depuis le terminal.

18. Utilisation d'un support de données selon la revendication 17, **caractérisé en ce que** des données supplémentaires sont des données concernant la sécurité.
